# EUROPÄISCHE PATENTSCHRIFT

(11) **EP 2 606 514 B1**
(45) Veröffentlichungstag und Bekanntmachung des Hinweises auf die Patenterteilung: **17.01.2018**
(21) Anmeldenummer: 11752154.2
(22) Anmeldetag: 18.08.2011
(51) Int. Cl.: F21K 9/00, H01L 33/64, F21V 29/85, H01L 33/62, H01L 33/48

(54) **OPTOELEKTRONISCHES HALBLEITERBAUELEMENT**
OPTOELECTRONIC SEMI-CONDUCTOR COMPONENT
COMPOSANT SEMI-CONDUCTEUR OPTOÉLECTRONIQUE

(30) Priorität: 20.08.2010 DE 102010034924
(43) Veröffentlichungstag der Anmeldung: 26.06.2013
(73) Patentinhaber: Osram Opto Semiconductors Gmbh, 93055 Regensburg (DE)
(72) Erfinder: ZITZLSPERGER, Michael, 93047 Regensburg (DE); RAMCHEN, Johann, 84032 Altdorf (DE)
(74) Vertreter: Epping - Hermann - Fischer
(86) Internationale Anmeldenummer: PCT/EP2011/064224
(87) Internationale Veröffentlichungsnummer: WO 2012/022782

(56) Entgegenhaltungen:
- US-A- 3 671 819
- US-A1- 2007 023 893
- US-A1- 2007 080 360
- US-A1- 2007 221 928
- US-A1- 2009 252 950
- US-A1- 2009 261 356

## Beschreibung

Es wird ein optoelektronisches Halbleiterbauelement angegeben.

Eine zu lösende Aufgabe besteht darin, ein optoelektronisches Halbleiterbauelement anzugeben, das platzsparend und kompakt im Aufbau ist.

Optoelektronische Bauelemente sind aus den Patentanmeldungen US 2007/0080360 A1, US 2007/0221928 A1, US 2009/0261356 A1 und US 2700/0023893 A1 bekannt.

Erfindungsgemäß umfasst das optoelektronische Halbleiterbauelement einen Träger, der eine Oberseite und eine der Oberseite gegenüberliegende Unterseite aufweist. Der Träger ist mit einem elektrisch leitenden Montagebereich, einem elektrisch leitenden Anschlussbereich sowie einem elektrisch isolierenden Oxidationsbereich gebildet.
Ferner umfasst das optoelektronische Halbleiterbauelement zumindest einen an der Oberseite des Trägers im Bereich des Montagebereichs angeordnetes optoelektronisches Bauteil. Der Oxidationsbereich isoliert den Montagebereich von dem Anschlussbereich elektrisch. Der Oxidationsbereich erstreckt sich unterbrechungsfrei von der Oberseite des Trägers hin zur Unterseite des Trägers. Der Montagebereich und der Anschlussbereich sind mit Aluminium gebildet, der Oxidationsbereich ist mit einem Oxid des Aluminiums gebildet ist. Der Montagebereich, der Oxidationsbereich und der Anschlussbereich sind zusammenhängend ausgebildet und bilden eine Einheit, ohne dass eine Unterbrechung oder ein Spalt zwischen den Bereichen auftritt. Das optoelektronische Halbleiterbauelement umfasst außerdem einen weiteren Oxidationsbereich, der an der Unterseite des Trägers im Bereich des Montagebereichs und/oder des Anschlussbereichs ausgebildet ist, wobei der weitere Oxidationsbereich den Träger in vertikaler Richtung an keiner Stelle vollständig ausbildet. Der weitere Oxidationsbereich bildet keine Einheit mit den anderen Oxidationsbereichen des Trägers und ist von anderen Oxidationsbereichen durch nicht oxidierte Bereiche des Trägers getrennt. Der Oxidationsbereich umrandet den Montagebereich und den Anschlussbereich vollständig und bildet einen vollständigen Randbereich des Trägers.
Gemäß zumindest einer Ausführungsform des optoelektronischen Halbleiterbauelements umfasst dieses einen Träger, der eine Oberseite und eine der Oberseite gegenüberliegende Unterseite aufweist. An der Oberseite und der Unterseite ist jeweils eine Fläche ausgebildet, die durch einen Teil der Außenfläche des Trägers gebildet ist. Die Fläche an der Unterseite ist der Teil der Außenflächen des Trägers, die einem Kontaktträger - beispielsweise einer Leiterplatte - im montierten Zustand des Trägers zugewandt ist. Zum Beispiel ist die Fläche an der Unterseite des Trägers eine Montagefläche, die zur Montage des späteren Halbleiterbauelements auf dem Kontaktträger dienen kann. Eine Fläche an der Unterseite des Halbleiterbauelements kann zumindest stellenweise durch die Fläche an der Unterseite des Trägers gebildet sein.
Der Träger ist mit einem elektrisch leitenden Montagebereich, einem elektrisch leitenden Anschlussbereich sowie einem elektrisch isolierenden Oxidationsbereich gebildet. Das heißt, dass der Träger die drei Bereiche umfasst, wobei sich der Oxidationsbereich von dem Montagebereich und dem Anschlussbereich zumindest hinsichtlich seines Materials unterscheidet. Das heißt, dass das Material des Oxidationsbereichs nicht identisch mit dem Material des Montagebereichs und/oder des Anschlussbereichs ist. "Bereich" ist in diesem Zusammenhang jede dreidimensionale Struktur, die den Träger zumindest stellenweise ausformt und bildet. Zum Beispiel bilden der Anschlussbereich, der Montagebereich und der Oxidationsbereich den Träger vollständig aus.

Gemäß zumindest einer Ausführungsform umfasst das optoelektronische Halbleiterbauelement zumindest ein an der Oberseite des Trägers im Bereich des Montagebereichs angeordnetes optoelektronisches Bauteil. Bei dem optoelektronischen Bauteil kann es sich insbesondere um einen strahlungsempfangenden oder um einen strahlungsemittierenden Halbleiterchip handeln. Beispielsweise handelt es sich bei dem Halbleiterchip um einen Lumineszenzdiodenchip, also um einen Leuchtdiodenchip oder um einen Laserdiodenchip. Beispielsweise ist das optoelektronische Bauteil mit einer Außenfläche auf eine Kontaktstelle des Trägers im Montagebereich gebondet, gelötet oder elektrisch leitend geklebt.

Gemäß zumindest einer Ausführungsform isoliert der Oxidationsbereich den Montagebereich von dem Anschlussbereich elektrisch. Das heißt, dass, zum Beispiel beim sachgemäßen Gebrauch des Halbleiterbauelements, ausgehend vom Montagebereich keine elektrisch leitende Verbindung durch den Oxidationsbereich hindurch in den Anschlussbereich und umgekehrt besteht.

Gemäß zumindest einer Ausführungsform erstreckt sich der Oxidationsbereich unterbrechungsfrei von der Oberseite des Trägers hin zur Unterseite des Trägers. Das heißt, dass zumindest eine gedachte Linie oder Strecke, welche die Oberseite und die Unterseite miteinander verbindet, durch den Träger verläuft und vollständig im Oxidationsbereich angeordnet ist.

Gemäß zumindest einer Ausführungsform sind der Montagebereich und der Anschlussbereich mit Aluminium gebildet. Beispielsweise sind der Montagebereich und der Anschlussbereich vollständig mit dem Aluminium gebildet. Zum Beispiel handelt es sich bei dem Träger um eine Aluminiumplatte welche zur Erzeugung des Oxidationsbereichs partiell oxidiert ist. Die nicht oxidierten Bereiche können dann den Montagebereich und/oder den Anschlussbereich bilden. Es hat sich herausgestellt, dass Aluminium zur Kontaktierung des optoelektronischen Bauteils besonders geeignet ist und zudem vom optoelektronischen Bauteil erzeugte Wärme von diesem weggeleitet werden kann. Mittels des Aluminiums kann also das optoelektronische Bauteil effizient gekühlt werden.

Gemäß zumindest einer Ausführungsform ist der Oxidationsbereich mit einem Oxid des Aluminiums gebildet. Beispielsweise handelt es sich bei dem Oxid um AlₓO_{y.} Zum Beispiel ist x=2 und y=3. Vorzugsweise ist ein derartiges Oxid elektrisch isolierend und weist zudem eine hohe Wärmeleitfähigkeit auf. Vorteilhaft kann vom optoelektronischen Bauteil erzeugte Wärme durch den Oxidationsbereich vom optoelektronischen Bauteil weggeleitet und beispielsweise gleichmäßig auf den ganzen Träger verteilt werden.

Gemäß zumindest einer Ausführungsform sind der Montagebereich, der Oxidationsbereich und der Anschlussbereich zusammenhängend ausgebildet und bilden eine Einheit. Dabei gehen die einzelnen Bereiche direkt ineinander über, sodass sich zwischen den einzelnen Bereichen weder ein Spalt noch eine Unterbrechung ausbildet. Gemäß zumindest einer Ausführungsform des optoelektronischen Halbleiterbauelements umfasst dieses einen Träger, der eine Oberseite und eine der Oberseite gegenüberliegende Unterseite aufweist, wobei der Träger mit einem elektrisch leitenden Montagebereich, einem elektrisch leitenden Anschlussbereich sowie einem elektrisch isolierenden Oxidationsbereich gebildet ist. Weiter ist zumindest ein optoelektronisches Bauteil an der Oberseite des Trägers im Bereich des Montagebereichs angeordnet. Der Oxidationsbereich isoliert den Montagebereich von dem Anschlussbereich elektrisch, wobei der Oxidationsbereich sich unterbrechungsfrei von der Oberseite des Trägers hin zur Unterseite des Trägers erstreckt. Der Montagebereich und der Anschlussbereich sind mit einem Aluminium gebildet, wobei der Oxidationsbereich mit einem Oxid des Aluminiums gebildet ist. Ferner sind der Montagebereich, der Oxidationsbereich und der Anschlussbereich zusammenhängend ausgebildet und bilden eine Einheit.

Gemäß zumindest einer Ausführungsform umfasst das optoelektronische Halbleiterbauelement zumindest einen weiteren Oxidationsbereich, der an der Unterseite des Trägers im Bereich des Montagebereichs und/oder des Anschlussbereichs ausgebildet ist, wobei der weitere Oxidationsbereich den Träger in vertikaler Richtung an keiner Stelle vollständig ausbildet. Das heißt, dass der weitere Oxidationsbereich zum Beispiel über die Unterseite des Trägers in den Träger von außen eingebracht sein kann und an der Unterseite des Trägers lediglich einen randseitigen Bereich des Trägers ausbildet. Zum Beispiel ist die Fläche an der Unterseite des Trägers stellenweise durch den weiteren Oxidationsbereich gebildet. Der weitere Oxidationsbereich bildet keine Einheit mit anderen Oxidationsbereichen des Trägers. Der weitere Oxidationsbereich ist durch nicht oxidierte Bereiche des Trägers von anderen Oxidationsbereichen des Trägers getrennt.
Der weitere Oxidationsbereich erstreckt sich zum Beispiel auf der Unterseite des Trägers im Bereich des strahlungsemittierenden Halbleiterchips. Das heißt, der weitere Oxidationsbereich kann sich gegenüberliegend zum strahlungsemittierenden Halbleiterchip an der Unterseite des Trägers befinden und umfasst zumindest eine Projektion der dem Träger zugewandten Oberfläche des Halbleiterchips auf die Unterseite des Trägers.

Gemäß zumindest einer Ausführungsform weist der weitere Oxidationsbereich eine maximale Dicke auf, die höchstens 25% der Dicke des Trägers entspricht. Unter Dicke versteht man dabei die Ausdehnung des Trägers in vertikaler Richtung. Mit anderen Worten ist der Oxidationsbereich im Vergleich zum Träger dünn ausgebildet.

Gemäß zumindest einer Ausführungsform ist der Oxidationsbereich in lateraler Richtung zumindest stellenweise zwischen dem Montagebereich und dem Anschlussbereich angeordnet. Beispielsweise beabstandet der Oxidationsbereich den Montagebereich von dem Anschlussbereich in lateraler Richtung. "Laterale Richtung" ist eine Richtung parallel zur Haupterstreckungsrichtung des Trägers. Der Oxidationsbereich kann ein Abstandshalter zwischen dem Montagebereich und dem Anschlussbereich sein.

Gemäß zumindest einer Ausführungsform umrandet der Oxidationsbereich den Montagebereich und den Anschlussbereich vollständig. Es ist möglich, dass der Oxidationsbereich den Montagebereich und den Anschlussbereich vollständig, beispielsweise rahmenförmig, umrandet und in lateraler Richtung einschließt. Der Oxidationsbereich bildet einen vollständigen Randbereich des Trägers.

Gemäß zumindest einer Ausführungsform beträgt eine Dicke des Trägers wenigstens 0,1 mm und höchstens 0,4 mm. "Dicke" heißt in diesem Zusammenhang eine Ausdehnung des Trägers in vertikaler Richtung. Dabei bedeutet "vertikale Richtung", eine Richtung senkrecht zur Haupterstreckungsrichtung des Trägers. Eine derartige Dicke des Trägers führt zu einem optoelektronischen Halbleiterbauelement mit einer besonders geringen vertikalen Ausdehnung. Mit anderen Worten ist das optoelektronische Halbleiterbauelement besonders flach.

Gemäß zumindest einer Ausführungsform umfasst das optoelektronische Halbleiterbauelement an der Unterseite des Trägers im Montagebereich und im Anschlussbereich angeordnete Anschlussstellen, die den Träger in lateraler Richtung nicht überragen. Das heißt, dass die Anschlussstellen von dem Träger in lateraler Richtung nicht weggeführt und aus dem Halbleiterbauelement seitlich nicht herausgeführt sind. Beispielsweise bilden Anschlussflächen der Anschlussstellen zumindest stellenweise eine Fläche an der Unterseite des Halbleiterbauelements aus, über die sie von außen außerhalb des Halbleiterbauelements elektrisch kontaktierbar sind. Die Anschlussstellen dienen zur elektrischen Kontaktierung des optoelektronischen Bauteils.

Gemäß zumindest einer Ausführungsform ist der Träger zumindest stellenweise von einem Gehäusekörper bedeckt. "Bedeckt" heißt in diesem Zusammenhang, dass der Gehäusekörper stellenweise mit dem Träger in direktem Kontakt steht und sich so an den Stellen zwischen dem Träger und dem Gehäusekörper weder ein Spalt noch eine Unterbrechung ausbildet. Vorteilhaft erhöht der Gehäusekörper die Stabilität des Halbleiterbauelements gegen äußere mechanische Belastungen, wie sie bei sachgemäßem Gebrauch des Halbleiterbauelements auftreten können. Insbesondere stabilisiert der Gehäusekörper den Träger, sodass während der Herstellung des Trägers und/oder des Halbleiterbauelements oder im Betrieb des Halbleiterbauelements eine Verformung und/oder Beschädigung des Trägers vermieden werden kann. Durch den Gehäusekörper kann daher eine Verformung des Trägers vermieden werden. Beispielsweise ist der Gehäusekörper strahlungsundurchlässig. "Strahlungsundurchlässig" bedeutet hierbei, dass der Gehäusekörper für auf ihn auftreffende elektromagnetische Strahlung wenigstens zu 80 %, bevorzugt zu mehr als 90 %, undurchlässig ist. Der Gehäusekörper kann mit einem duro- oder thermoplastischen Material, beispielsweise einem Epoxid, gebildet sein oder auch mit einem keramischen Material gebildet sein oder aus einem solchen bestehen. In das Material können zusätzlich strahlungsabsorbierende Materialien, beispielsweise Rußpartikel oder andere Füllstoffe, eingebracht sein. Der Gehäusekörper kann dann für einen externen Betrachter schwarz oder farbig erscheinen. Gemäß zumindest einer Ausführungsform ist der Träger zumindest stellenweise in den Gehäusekörper eingebettet. Das kann heißen, dass der Träger bis auf Stellen an denen die Anschlussstellen am Träger angeordnet sind sowie einen Anschlussbereich für das optoelektronische Bauteil an der Oberseite des Trägers im Bereich des Montagebereichs von dem Gehäusekörper umschlossen ist. Beispielsweise fasst der Gehäusekörper die Anschlussstellen des Halbleiterbauteils zumindest stellenweise formschlüssig ein. Die Fläche an der Unterseite des Trägers kann dann stellenweise von dem Gehäusekörper bedeckt sein. Beispielsweise schließen die Anschlussstellen vertikal bündig mit dem Gehäusekörper ab. Das heißt, die Anschlussstellen befinden sich an der Unterseite des Trägers und ragen nicht über den Gehäusekörper hinaus. Ebenso ist denkbar, dass die Fläche an der Unterseite des Trägers vollständig frei von dem Gehäusekörper ist. Zumindest an den Anschlussflächen sind die Anschlussstellen nicht vom Gehäusekörper eingefasst. Gemäß zumindest einer Ausführungsform ist zumindest eine Seitenfläche des Halbleiterbauelements mittels Vereinzeln erzeugt, wobei die Seitenfläche durch eine Außenfläche des Oxidationsbereichs gebildet ist. Die zumindest eine Seitenfläche des Halbleiterbauelements begrenzt das Halbleiterbauelement in lateraler Richtung, also seitlich. Zum Beispiel verläuft die Seitenfläche senkrecht zur Fläche an der Unterseite und/oder der Oberseite des Trägers. Insbesondere sind Konturformen der Seitenfläche, also nicht durch einen Guss- oder Pressprozess erzeugt, sondern mittels eines Vereinzelungsprozesses zumindest des des Trägers. Das Vereinzeln kann beispielsweise mittels Sägen, Schneiden, Fräsen oder Herstellen einer Bruchkante und anschließendes Brechen erfolgen. Die Seitenfläche des Halbleiterbauelements ist damit mittels eines Materialabtrags erzeugt. Die Seitenfläche weist dann bevorzugt Spuren eines Materialabtrags auf. Wird bei der Herstellung des Halbleiterbauelements sowohl durch den Gehäusekörper als auch durch den Oxidationsbereich des Trägers vereinzelt, geschnitten oder gebrochen, so schließt die Außenfläche des Oxidationsbereichs lateral bündig mit einer Außenfläche des Gehäusekörper ab. Die Seitenfläche ist dann sowohl stellenweise durch die Außenfläche des Gehäusekörpers als auch stellenweise durch die Außenfläche des Trägers gebildet.

Im Folgenden wird das hier beschriebene optoelektronische Halbleiterbauelement sowie ein Verfahren zu dessen Herstellung anhand von Ausführungsbeispielen und den dazugehörigen Figuren näher erläutert.
- Die Figur 1A: zeigt in einer schematischen Seitenansicht eine Abwandlung eines hier beschriebenen optoelektronischen Halbleiterbauelements.
- Die Figuren 1B bis 1E: zeigen in schematischen Draufsichten Abwandlungen und Ausführungsbeispiele eines hier beschriebenen Trägers.
- Die Figuren 2A bis 2F: zeigen einzelne Fertigungsschritte zur Herstellung eines hier beschriebenen optoelektronischen Halbleiterbauelements.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

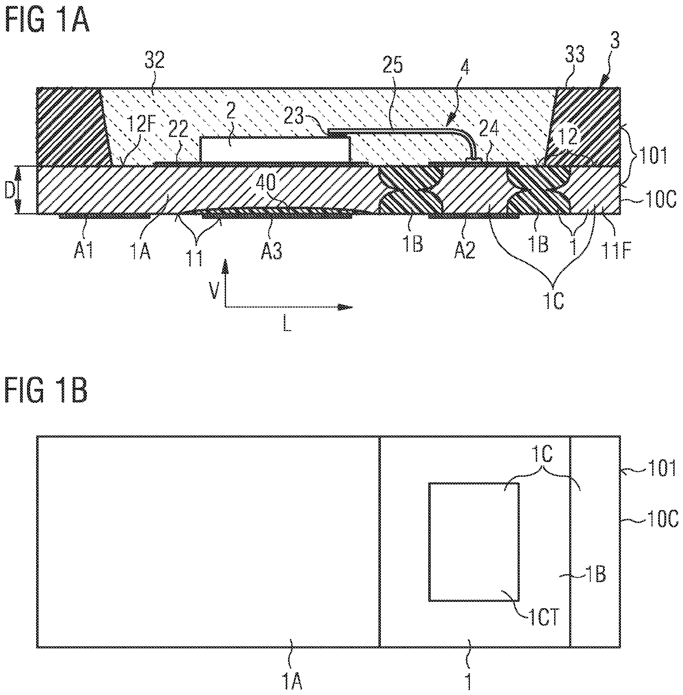

Die Figur 1A zeigt in einer schematischen Schnittansicht eine Abwandlung eines hier beschriebenen optoelektronischen Halbleiterbauelements 100 mit einem Träger 1, der eine Oberseite 12 und eine der Oberseite 12 gegenüberliegende Unterseite 11 aufweist. Der Träger 1 ist mit einem elektrisch leitenden Montagebereich 1A, einem elektrisch leitenden Anschlussbereich 1C sowie einem elektrisch isolierenden Oxidationsbereich 1B gebildet. Auf eine Fläche 12F an der Oberseite 12 des Trägers 1 ist im Montagebereich 1A ein optoelektronisches Bauteil 2 aufgebracht, wobei zur Kontaktierung des optoelektronischen Bauteils 2 zwischen dem Träger 1 und dem optoelektronischen Bauteil 2 eine elektrisch leitfähige Kontaktschicht 22 angeordnet ist. Weiter sind auf eine Fläche 11F an der Unterseite 11 des Trägers 1 im Montagebereich 1A und im Anschlussbereich 1C Anschlussstellen A1 und A2 angeordnet und auf die Fläche 11F aufgebracht. Zudem ist auf eine dem Träger 1 abgewandte Außenfläche des optoelektronischen Bauteils 2 eine Kontaktfläche 23 aufgebracht. Mittels einer Bonddrahtkontaktierung 25 ist die Kontaktfläche 23 mit einer auf die Fläche 12F an der Oberseite 12 des Trägers 1 im Anschlussbereich 1B aufgebrachte weitere Kontaktfläche 24 elektrisch leitend verbunden. Sowohl der Montagebereich 1A als auch der Anschlussbereich 1C sind vollständig mit einem Aluminium 10 gebildet, wobei der Oxidationsbereich 1B mit einem Oxid 15 des Aluminiums 10 gebildet ist. Dabei erstreckt sich der Oxidationsbereich 1B unterbrechungsfrei von der Oberseite 12 des Trägers 1 hin zur Unterseite 11 des Trägers 1. Mit anderen Worten ist der Oxidationsbereich 1B in vertikaler Richtung V zusammenhängend und durchgehend ausgebildet. Der Montagebereich 1A, der Oxidationsbereich 1B und der Anschlussbereich 1C bilden eine Einheit und sind ebenso zusammenhängend ausgebildet. Eine Dicke D des Trägers beträgt wenigstens 0,1 mm und höchstens 0,4 mm, beispielsweise 0,2 mm.

Der Träger 1 ist stellenweise in einen Gehäusekörper 3 eingebettet. Das heißt, dass der Träger 1 über seine Fläche 12F an der Oberseite 12 stellenweise in direktem Kontakt mit dem Gehäusekörper 3 ist. Der Gehäusekörper 3 bedeckt bis auf einen Anschlussbereich der Fläche 12F an der Oberseite 12 des Trägers 1 die Fläche 12F vollständig. Durch den Gehäusekörper 3 und die Fläche 12F an der Oberseite 12 des Trägers 1 ist eine Kavität 32 definiert, in der das optoelektronische Bauteil 2 angeordnet ist. Der Gehäusekörper 3 umrandet dabei das optoelektronische Bauteil 2 in lateraler Richtung L vollständig. Vorliegend ist in die Kavität 32 ein Verguss 4 eingebracht, der alle freiliegenden Stellen des optoelektronischen Bauteils 2 bedeckt. Vorzugweise ist der Verguss 4 mit einem strahlungsdurchlässigen Vergussmaterial, wie zum Beispiel einem Silikon, einem Epoxid oder einer Mischung aus einem Silikon oder einem Epoxid gebildet. "Strahlungsdurchlässig" heißt in diesem Zusammenhang, dass das Vergussmaterial des Vergusses 4 für von vom optoelektronischen Bauteil 2 emittierte elektromagnetische Strahlung wenigstens zu 80 %, bevorzugt zu mehr als 90 % durchlässig ist. Zum Beispiel ist der Verguss 4 mittels Vergießens, Molding oder Jetten in die Kavität 32 eingebracht. Denkbar ist auch, dass in das strahlungsdurchlässige Vergussmaterial Füllstoffe wie zum Beispiel ein Lumineszenzkonversionsmaterial und/oder ein Filtermaterial eingebracht sind.

Zum Beispiel sind in das Vergussmaterial ausgehend von der Fläche 12F des Trägers 1 bis zur Höhe einer Strahlungsdurchtrittsfläche des optoelektronischen Bauteils 2 strahlungsreflektierende Partikel eingebracht. Bis zu dieser Füllhöhe ist der Verguss 4 dann strahlungsreflektierend ausgebildet. Ebenso kann die Kavität 32 auch nur bis zur Höhe der Strahlungsdurchtrittsfläche mit dem strahlungsreflektierenden Verguss 4 befüllt sein. Zum Beispiel sind die strahlungsreflektierenden Partikel mit zumindest einem der Materialien TiO₂, BaSO₄, ZnO, AlₓO_{y} gebildet oder enthalten zumindest eines der Materialien. Der Verguss 4 kann dann für einen externen Betrachter weiß erscheinen.

Die auf der Fläche 11F an der Unterseite 11 des Trägers 1 aufgebrachten Anschlussstellen A1 und A2 überragen den Träger 1 in der lateralen Richtung L nicht. Insbesondere ist das in der Figur 1A gezeigte optoelektronische Halbleiterbauelement 100 oberflächenmontierbar. Ferner weist das optoelektronische Bauelement 100 einen weiteren Oxidationsbereich 40 auf, der an der Unterseite 11 des Trägers 1 im Montagebereichs 1A ausgebildet ist. Dabei bildet der weitere Oxidationsbereich 40 den Träger 1 in der vertikalen Richtung V an keiner Stelle vollständig aus. Vorliegend ist der weitere Oxidationsbereich 40 von außen von der Unterseite 11 her in den Träger 1 eingebracht und bildet einen Randbereich des Trägers 1 an der Unterseite 11 aus. Mit anderen Worten ist die Fläche 11F an der Unterseite 11 stellenweise durch eine Außenfläche des Oxidationsbereichs 40 gebildet. Auf die Fläche 11F im Bereich des Oxidationsbereichs 40 ist ein Kontaktelement A3, zum Beispiel ein Lötpad, aufgebracht, welches durch den Oxidationsbereich 40 vom Rest des Trägers 1 elektrisch isoliert ist. Zum Beispiel dient das Kontaktelement A3 zur Befestigung des Halbleiterbauelements 100 auf einem Kontaktträger. Beispielsweise ist das Halbleiterbauelement 100 über das Kontaktelement A3 mittels Löten auf einem solchen Kontaktträger mechanisch befestigt.

Eine Seitenfläche 101 des Halbleiterbauelements 100 ist mittels Vereinzeln erzeugt. In der Figur 1A ist dargestellt, dass die Seitenfläche 101 durch eine Außenfläche 33 des Gehäusekörpers 3 und eine Außenfläche 10C des Anschlussbereichs 1C gebildet ist.

Die Figuren 1B bis 1D zeigen in schematischen Draufsichten Abwandlungen und Ausführungsbeispiele eines hier beschriebenen Trägers 1.

Die Figur 1B zeigt den Träger 1 der Figur 1A. Der Figur 1B ist entnehmbar, dass der Oxidationsbereich 1B einen Teilbereich 1CT des Anschlussbereich 1C vollständig umrandet und in der lateralen Richtung L einschließt. In Bezug auf den ganzen Anschlussbereich 1C umrandet der Oxidationsbereich 1B den Anschlussbereich nur stellenweise. Dabei beabstandet der Oxidationsbereich 1B den Teilbereich 1CT in lateraler Richtung L von dem Montagebereich 1A.

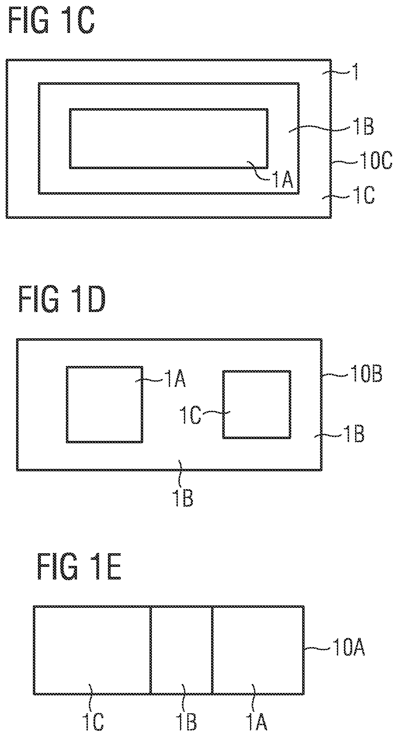

Bei dem Träger 1 der Figur 1C umrandet der Anschlussbereich 1C sowohl den Oxidationsbereich 1B als auch den Montagebereich 1A vollständig, also rahmenförmig, wobei zusätzlich der Montagebereich 1A von dem Oxidationsbereich 1B vollständig umrandet ist.

In der Figur 1D ist gezeigt, dass der Oxidationsbereich 1B sowohl den Montagebereich 1A als auch den Anschlussbereich 1C in lateraler Richtung L vollständig umrandet. Dabei ist in der Figur 1D eine Außenfläche 10B gezeigt, die die Seitenfläche 101 des Halbleiterbauelements 100, zum Beispiel zusammen mit der Außenfläche 33 des Gehäusekörpers 3, bilden kann.

In der Figur 1E ist sind der Montagebereich 1A, der Oxidationsbereich 1B und der Anschlussbereich 1C in Form von Streifen ausgebildet und in der lateralen Richtung L nebeneinander angeordnet. Das heißt, dass der Oxidationsbereich 1B den Montagebereich 1A von dem Anschlussbereich 1C in lateraler Richtung L beabstandet und die einzelnen Bereiche in lateraler Richtung L aufeinander folgen. Dabei ist in der Figur 1E eine Außenfläche 10A gezeigt, die die Seitenfläche 101 des Halbleiterbauelements 100, zum Beispiel zusammen mit der Außenfläche 33 des Gehäusekörpers 3, bilden kann.

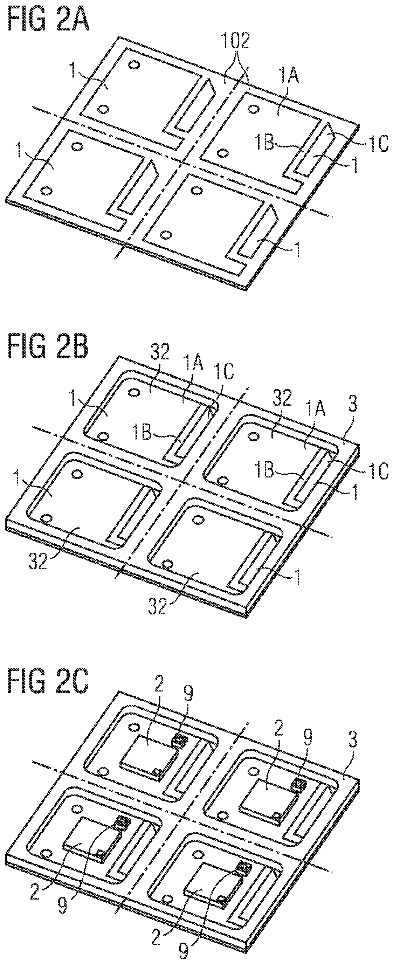

Die Figuren 2A bis 2F zeigen in schematischen Ansichten einzelne Fertigungsschritte zur Herstellung eines hier beschriebenen optoelektronischen Halbleiterbauelements 100. Das heißt, sämtliche in Verbindung mit dem hier beschriebenen Halbleiterbauelement 100 offenbarten Merkmale sind auch für das Verfahren offenbart und umgekehrt.

In der Figur 2A ist ein Trägerverbund 102 dargestellt, der durch eine Vielzahl von matrixartig angeordneten hier beschriebenen Trägern 1 gebildet ist.

In der Figur 2B ist dargestellt, wie in einem nächsten Schritt der Gehäusekörper 3 jeweils auf die Fläche 12F an der Oberseite 12 des Trägers 1 aufgebracht wird.

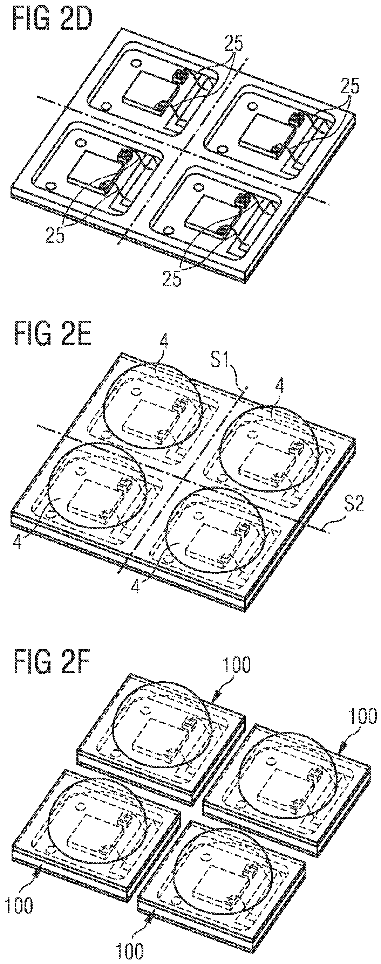

In einem nächsten Schritt ist in der Figur 2C dargestellt, wie auf die Fläche 12F an der Oberseite 12 jedes Trägers 1 im Bereich des Montagebereichs 1A das optoelektronische Bauteil 2 aufgebracht wird. Ferner ist aus der Figur 2 erkennbar, dass ebenso ein elektronisches Bauteil 9 im gleichen Bereich auf der Fläche 12F an der Oberseite 12 auf dem Träger 1 angeordnet wird. Beispielsweise enthält oder ist das elektronische Bauteil 9 eine Schutzschaltung gegen Schäden durch elektrostatische Aufladung (auch ESD-Schutzschaltung).

In der Figur 2D ist dargestellt, wie sowohl das optoelektronische Bauteil 2 als auch das elektronische Bauteil 9 mit dem Anschlussbereich 1C mittels der Bonddrahtkontaktierung 25 elektrisch kontaktiert werden.

In der Figur 2E ist ein weiterer Schritt dargestellt, bei dem in die Kavität 32 jeweils ein strahlungsdurchlässiger Verguss 4 eingebracht wird, wobei eine dem optoelektronischen Bauteil 2 abgewandte Außenfläche des strahlungsdurchlässigen Vergusses 4 in Bezug auf das optoelektronische Bauteil 2 stellenweise konvex, zum Beispiel linsenförmig, ausgebildet ist. Der strahlungsdurchlässige Verguss 4 bedeckt alle freiliegenden Stellen optoelektronischen Bauteils 2 vollständig und füllt die Kavität 32 vollständig aus.

In der Figur 2F ist ein nächster Schritt dargestellt, bei dem der Trägerverbund 102 entlang von Vereinzelungslinien S1 und S2 vereinzelt wird und damit einzelne optoelektronische Halbleiterbauelemente 100 erzeugt werden.

Die Erfindung ist nicht durch die Beschreibung anhand der Ausführungsbeispiele beschränkt. Vielmehr erfasst die Erfindung jedes neue Merkmal sowie jede Kombination von Merkmalen, was insbesondere jede Kombination von Merkmalen in den Patentansprüchen beinhaltet.

Diese Patentanmeldung beansprucht die Priorität der deutschen Patentanmeldung 102010034924.0.

## Patentansprüche

1. Optoelektronisches Halbleiterbauelement (100), mit
- einem Träger (1) der eine Oberseite (12) und eine der Oberseite (12) gegenüberliegende Unterseite (11) aufweist, wobei der Träger (1) mit einem elektrisch leitenden Montagebereich (1A), einem elektrisch leitenden Anschlussbereich (1C) sowie einem elektrisch isolierenden Oxidationsbereich (1B) gebildet ist;
- zumindest einem an der Oberseite des Trägers (1) im Bereich des Montagebereichs (1A) angeordnetes optoelektronisches Bauteil (2),
wobei
- der Oxidationsbereich (1B) den Montagebereich (1A) von dem Anschlussbereich (1C) elektrisch isoliert,
- der Oxidationsbereich (1B) sich unterbrechungsfrei von der Oberseite (12) des Trägers (1) hin zur Unterseite (11) des Trägers (1) erstreckt,
- der Montagebereich (1A) und der Anschlussbereich (1C) mit Aluminium (10) gebildet sind,
- der Oxidationsbereich (1B) mit einem Oxid (15) des Aluminiums (10) gebildet ist, und
- der Montagebereich (1A), der Oxidationsbereich (1B) und der Anschlussbereich (1C) zusammenhängend ausgebildet sind und eine Einheit bilden, ohne dass eine Unterbrechung oder ein Spalt zwischen den Bereichen auftritt, und
- mit zumindest einem weiteren Oxidationsbereich (40), der an der Unterseite (11) des Trägers (1) im Bereich des Montagebereichs (1A) und/oder des Anschlussbereichs (1C) ausgebildet ist, wobei der weitere Oxidationsbereich (40) den Träger (1) in vertikaler Richtung (V) an keiner Stelle vollständig ausbildet,
**dadurch gekennzeichnet dass**
- der weitere Oxidationsbereich (40) keine Einheit mit den anderen Oxidationsbereichen (1B) des Trägers (1) bildet und von anderen Oxidationsbereichen durch nicht oxidierte Bereiche des Trägers (1) getrennt ist,
- der Oxidationsbereich (1B) den Montagebereich (1A) und den Anschlussbereich (1C) vollständig umrandet und einen vollständigen Randbereich des Trägers (1) bildet.

2. Optoelektronisches Halbleiterbauelement (100) nach dem vorherigen Anspruch, bei dem der Oxidationsbereich (1B) in lateraler Richtung (L) zumindest stellenweise zwischen dem Montagebereich (1A) und dem Anschlussbereich (1C) angeordnet ist.

3. Optoelektronisches Halbleiterbauelement (100) nach einem der vorherigen Ansprüche, bei dem eine Dicke des Trägers (1) wenigstens 0,1 mm und höchstens 0,4 mm beträgt.

4. Optoelektronisches Halbleiterbauelement (100) nach einem der vorherigen Ansprüche, mit an der Unterseite (11) des Trägers (2) im Montagebereich (1A) und im Anschlussbereich (1C) angeordneten Anschlussstellen (A1, A2), die den Träger (1) in lateraler Richtung (L) nicht überragen.

5. Optoelektronisches Halbleiterbauelement (100) nach einem der vorherigen Ansprüche, bei dem der Träger (1) zumindest stellenweise von einem Gehäusekörper (3) bedeckt ist.

6. Optoelektronisches Halbleiterbauelement (100) nach dem vorherigen Anspruch, bei dem der Träger (1) zumindest stellenweise in den Gehäusekörper (3) eingebettet ist.

7. Optoelektronisches Halbleiterbauelement (100) nach einem der vorherigen Ansprüche, bei dem zumindest eine Seitenfläche (101) des Halbleiterbauelements (100) Spuren eines Materialabtrags aufweisen, wobei die Seitenfläche (101) zumindest stellenweise durch eine Außenfläche (10B) des Oxidationsbereich (1B) gebildet ist.

## Claims

1. Optoelectronic semiconductor component (100), comprising
- a carrier (1) having a top side (12) and an underside (11) situated opposite the top side (12), wherein the carrier (1) is formed with an electrically conductive mounting region (1A), an electrically conductive connection region (1C) and also an electrically insulating oxidation region (1B) ;
- at least one optoelectronic element (2) arranged at the top side of the carrier (1) in the region of the mounting region (1A), wherein
- the oxidation region (1B) electrically insulates the mounting region (1A) from the connection region (1C),
- the oxidation region (1B) extends without interruption from the top side (12) of the carrier (1) toward the underside (11) of the carrier (1),
- the mounting region (1A) and the connection region (1C) are formed with aluminum (10),
- the oxidation region (1B) is formed with an oxide (15) of the aluminum (10), and
- the mounting region (1A), the oxidation region (1B) and the connection region (1C) are embodied in a contiguous fashion and form one unit without an interruption or a gap occurring between the regions, and
- comprising at least one further oxidation region (40) formed at the underside (11) of the carrier (1) in the region of the mounting region (1A) and/or of the connection region (1C), wherein the further oxidation region (40) does not completely form the carrier (1) at any place in a vertical direction (V),
**characterized in that**
- the further oxidation region (40) does not form a unit with the other oxidation regions (1B) of the carrier (1) and is separated from other oxidation regions by non-oxidized regions of the carrier (1),
- the oxidation region (1B) borders the mounting region (1A) and the connection region (1C) completely and forms a complete edge region of the carrier (1).

2. Optoelectronic semiconductor component (100) according to the preceding claim,
wherein the oxidation region (1B) is arranged at least in places between the mounting region (1A) and the connection region (1C) in a lateral direction (L).

3. Optoelectronic semiconductor component (100) according to any of the preceding claims,
wherein a thickness of the carrier (1) is at least 0.1 mm and at most 0.4 mm.

4. Optoelectronic semiconductor component (100) according to any of the preceding claims,
comprising connection places (A1, A2) which are arranged at the underside (11) of the carrier (2) in the mounting region (1A) and in the connection region (1C) and which do not project beyond the carrier (1) in a lateral direction (L).

5. Optoelectronic semiconductor component (100) according to any of the preceding claims,
wherein the carrier (1) is covered by a housing body (3) at least in places.

6. Optoelectronic semiconductor component (100) according to the preceding claim,
wherein the carrier (1) is embodied into the housing body (3) at least in places.

7. Optoelectronic semiconductor component (100) according to any of the preceding claims,
wherein at least one side area (101) of the semiconductor component (100) has traces of a material removal, wherein the side area (101) is formed by an outer area (10B) of the oxidation region (1B) at least in places.

## Revendications

1. Dispositif optoélectronique semiconducteur (100), avec
- un substrat (1) qui comporte une face supérieure (12) et une face inférieure (11) au vis-à-vis de la face supérieure (12), le substrat (1) étant formé avec une zone de montage (1A) conductrice électrique, une zone de raccordement (1C) conductrice électrique ainsi qu'une zone d'oxydation (1B) électrique isolante,
- au moins un composant (2) optoélectronique, placé sur la face supérieure du substrat (1), dans la région de la zone de montage (1A),
- la zone d'oxydation (1B) isolant électriquement la zone de montage (1A) de la zone de raccordement (1C),
- la zone d'oxydation (1B) s'étendant sans interruption de la face supérieure (12) du substrat (1) jusqu'à la face inférieure (11) du substrat (1),
- la zone de montage (1A) et la zone de raccordement (1C) étant formées avec de l'aluminium (10),
- la zone d'oxydation (1B) étant formée avec un oxyde (15) de l'aluminium (10) et
- la zone de montage (1A), la zone d'oxydation (1B) et la zone de raccordement (1C) étant conçues de manière cohérente et formant une unité, sans qu'une interruption ou une fente n'apparaisse entre les zones et
- avec au moins une zone d'oxydation (40) supplémentaire qui est conçue sur la face inférieure (11) du substrat (1), dans la région de la zone de montage (1A) et/ou de la zone de raccordement (1C), en aucun endroit, la zone d'oxydation (40) supplémentaire ne formant complètement le substrat (1) dans la direction verticale (V),
**caractérisé en ce que**
- la zone d'oxydation (40) supplémentaire ne forme aucune unité avec les autres zones d'oxydation (1B) du substrat (1) et est séparée d'autres zones d'oxydation par des régions non oxydées du substrat (1),
- la zone d'oxydation (1B) borde complètement la zone de montage (1A) et la zone de raccordement (1C) et forme une zone de bordure complète du substrat (1).

2. Dispositif optoélectronique semiconducteur (100) selon la revendication précédente,
sur lequel dans la direction latérale (L), la zone d'oxydation (1B) est placée au moins par endroits entre la zone de montage (1A) et la zone de raccordement (1C).

3. Dispositif optoélectronique semiconducteur (100) selon l'une quelconque des revendications précédentes,
sur lequel une épaisseur du substrat (1) s'élève à au moins 0,1 mm et au plus 0,4 mm.

4. Dispositif optoélectronique semiconducteur (100) selon l'une quelconque des revendications précédentes,
avec des points de raccordement (A1, A2) placés sur la face inférieure (11) du substrat (2), dans la zone de montage (1A) et dans la zone de raccordement (1C), qui ne débordent pas par-dessus le substrat (1) dans la direction latérale (L).

5. Dispositif optoélectronique semiconducteur (100) selon l'une quelconque des revendications précédentes,
sur lequel le substrat (1) est recouvert au moins par endroits par un corps de boîtier (3).

6. Dispositif optoélectronique semiconducteur (100) selon la revendication précédente,
sur lequel le substrat (1) est noyé au moins par endroits dans le corps de boîtier (3).

7. Dispositif optoélectronique semiconducteur (100) selon l'une quelconque des revendications précédentes,
sur lequel au moins une surface latérale (101) du dispositif semiconducteur (100) comporte des traces d'un enlèvement de matière, la surface latérale (101) étant formée au moins par endroits par une surface extérieure (10B) de la zone d'oxydation (1B).
